# EUROPÄISCHE PATENTSCHRIFT

(11) **EP 2 511 956 B1**
(45) Veröffentlichungstag und Bekanntmachung des Hinweises auf die Patenterteilung: **19.02.2020**
(21) Anmeldenummer: 12002087.0
(22) Anmeldetag: 23.03.2012
(51) Int. Cl.: H01L 31/02, H02H 3/02, H02H 3/20, H02J 3/38

(54) **Drei-Schalter Überspannungsschutz für eine Photovoltaikanlage**
Three-circuit voltage spike protection for a photovoltaic system
Protection contre les surtensions à trois commutateurs pour une installation photovoltaïque

(30) Priorität: 16.04.2011 DE 102011017362
(43) Veröffentlichungstag der Anmeldung: 17.10.2012
(73) Patentinhaber: Adensis GmbH, 01129 Dresden (DE)
(72) Erfinder: Beck, Bernhard, 97332 Volkach/Dimbach (DE)
(74) Vertreter: Bauer, Daniel

(56) Entgegenhaltungen:
- EP-A1- 2 249 393
- EP-A2- 2 101 391
- EP-A2- 2 256 822
- US-A1- 2009 101 191

## Beschreibung

Die Erfindung betrifft eine Photovoltaikanlage mit einem Photovoltaikgenerator, welcher mehrere parallel angeordnete Stränge von in Serie verbundenen Photovoltaikmodulen umfasst, wobei die Stränge einen Plus- und einen Minuspol aufweisen zwischen denen eine über die Anzahl der in Serie geschalteten Photovoltaikmodule vorgebbare Strangspannung anliegt, die im Leerlauffall des Photovoltaikgenerators mehr als 1000 Volt beträgt, und mit einem Wechselrichter, dessen Gleichspannungseingang mit den beiden Polen verbunden ist, und der ausgangsseitig mit einem Versorgungsnetz verbindbar ist
Bei der Auslegung von Photovoltaikanlagen ist es zu beachten, dass die maximal zulässige Spannung U_{z} zwischen dem Plus- und dem Minuspol an der Gleichstromseite des Wechselrichters unter keinen Umständen überschritten wird, da ein Überschreiten zu einer Zerstörung des Wechselrichters und des Teils der Photovoltaikmodule, an welchem eine Spannung oberhalb einer zulässigen Spannung anliegt, führt.

Aus diesem Grund ist es zur Zeit üblich, die Photovoltaikanlage so auszulegen, dass selbst im ungünstigsten Fall eines Leerlaufs die Leerlaufspannung U_{L} oder U₀ unterhalb der zulässigen Maximalspannung U_{z} bleibt. Eine typische Auslegung sieht vor, dass eine Vielzahl von Strängen parallel geschaltet wird. Die maximale Anzahl der Stränge richtet sich dabei nach der Leistung des Wechselrichters, an den die Stränge angeschlossen sind. Moderne Wechselrichter können bis zu einer Eingangsgleichspannung von ca. 900 Volt - 1000 Volt ausgelegt sein.

Eine typische Ausführung sieht vor, jeden Strang der Anlage aus elf Photovoltaikmodulen aufzubauen, von denen jedes 120 Photovoltaikzellen aufweist. Insgesamt sind somit 1320 Zellen in Reihe zueinander geschaltet. An jeder Zelle liegt im Leerlauffall eine Spannung von 0,75 Volt an, was zu einer Strangspannung von 990 Volt führt, was unter der von den Herstellern der Module angegebenen Maximalspannung von 1000 Volt liegt.

Im Betrieb der Anlage sinkt die Leerlaufspannung der Zellen auf eine Betriebsspannung von ca. 0,5 Volt, so dass zwischen den Enden der herkömmlichen Stränge eine Spannung von 660 Volt anliegt. Sollte der Netzbetreiber, an den die Photovoltaikanlage angeschlossen ist, diese aus welchen Gründen auch immer ungeplant vom Netz nehmen (e.g. Kurzschluss in dem Einspeisekabel) springt die Spannung auf die genannten 990 Volt, was für die Module und die Anlage unkritisch ist. Liegt eine höhere Spannung an, kann dies zur Zerstörung eines Teils der Module, des Wechselrichters und der gesamten Anlage führen.

Auf der anderen Seite wäre es wünschenswert, insbesondere in Hinblick auf kürzlich vorgestellte neuartige PV-Module mit höheren Nenn- und Leerlaufspannungen, die Photovoltaik-Module und auch den Wechselrichter im Normalbetrieb mit einer höheren Spannung als 660 Volt, ideale Weise mit der zulässigen Höchstspannung von 1000 Volt zu betreiben. Zur besseren Ausnutzung der Isolationsfestigkeit der Verkabelung von in der Regel 1000 Volt ist es auch wünschenswert, die Anzahl der Module pro Strang zu erhöhen, um die 1000 Volt im Betrieb der PV-Anlage auszunutzen. Dieses ist aber nicht ohne weiteres möglich, da dann im Leerlauffall eine Spannung von ca. 1500 Volt zur Zerstörung der Photovoltaik-Module und des Wechselrichters und der Anlage führen würde.

Zur Vermeidung von diesen unzulässig hohen Spannungen ist es auf dem Fachgebiet bekannt, zwischen dem Pluspol und dem Minuspol einen Kurzschlussschalter zu setzen, der im Falle einer unzulässig hohen Spannung zwischen den Polen diese kurzschließt. Eine solche Schutzschaltung ist zum Beispiel in dem Dokument EP 2 249 393 A1 offenbart. Weiterhin ist es bekannt, den Pluspol oder den Minuspol auf ein festes zulässiges Potential von z.B. den genannten 1000 Volt zu fixieren, und die PV-Anlage im Betrieb von diesem Potential aus nach unten oder nach oben schweben zu lassen, was in der Regel als floaten bezeichnet wird.

Diese Maßnahme ist für Anlagen mit einem frei schwebenden Potential nicht möglich. Bei solchen Anlagen mit einem frei floatenden Potential des Plus- und des Minuspols treten z.B. Potentiale gegenüber einer virtuellen Erde von plus 600 Volt bis - 600 Volt auf. Virtuelle Erde bedeutet dabei, dass die Stränge an keiner Stelle mit Erde verbunden sind, würde man allerdings die Strangmitte auf Erde setzen, würden entsprechende Spannungen von +600 Volt und -600 Volt des Pluspols bzw. des Minuspols gegenüber der geerdeten Strangmitte anfallen. Für solche Anlagen ist es bekannt, einen Schalter zwischen der Strangmitte und Erde vorzusehen, der im Falle eines Erdfehlers geschlossen wird und die Strangmitte real erdet. Im Ergebnis fallen dann lediglich noch Spannungen bis zu 600 Volt an den Modulen an. Diese Maßnahme ist mit einem erheblichen Verkabelungsaufwand verbunden, da die Mitte jeden Strangs über den Schalter erreichbar sein muss. Bei der Verwendung von TCO Modulen treten darüber hinaus Korrosionsprobleme auf, weil aufgrund von Kathodenentladung der Rand der Module erodiert wird.

Der Erfindung liegt daher die Aufgabe zugrunde, eine Photovoltaikanlage mit frei schwebenden oder frei verschiebbaren Potential mit einer Schutzvorrichtung zu versehen, die den Betrieb mit einer hohen Betriebsspannung von z.B. 1500 Volt erlaubt und dabei sicherzustellen, dass keine unzulässigen Spannungsüberschreitungen an einem Modul oder am Eingang des Wechselrichters auftreten, insbesondere in Hinblick auf die IEC-Normen.

Diese Aufgabe wird erfindungsgemäß dadurch gelöst, dass der Pluspol und der Minuspol über ein erstes, beziehungsweise über ein zweites Schaltelement mit dem Gleichspannungseingang des Wechselrichters verbunden sind, dass eine Steuervorrichtung vorgesehen ist, mittels der zumindest eines der beiden Schaltelemente geöffnet wird, wenn die Spannung des Pluspols gegenüber Erde einen ersten vorgegebenen Grenzwert übersteigt oder wenn die Spannung des Minuspols gegenüber Erde einen zweiten vorgegebenen Grenzwert dem Betrage nach überschreitet, und dass die Steuervorrichtung ein drittes, zwischen dem Pluspol und dem Minuspol angeordnetes Schaltelement schließt, während das erste oder das zweite Schaltelement öffnet oder wenn zumindest eines geöffnet ist, wobei das geschlossene dritte Schaltelement den Pluspol und den Minuspol miteinander verbindet. Bezüglich des Minuspols ist der zweite vorgebbare Grenzwert absolut zu sehen. Das bedeutet, dass ein Potential von - 1050 Volt gegenüber Erde dem Betrage nach größer ist als - 1000 Volt gegenüber Erde, nämlich um 50 Volt größer, obwohl das Potential von -1050 Volt unter Einbeziehung des Vorzeichens minus eigentlich kleiner ist als -1000 Volt.

Durch diese Maßnahme wird sichergestellt, dass an den Komponenten der Anlage, insbesondere an den Modulen und dem Wechselrichter keine unzulässig hohe Spannung Uz gegen Erde im Leerlauffall auftritt. Durch die hohe Betriebsspannung von z.B. 1000 Volt unter Last können bei gleicher Leistung der PV-Anlage Kabel mit dünneren Leitungsquerschnitten eingesetzt werden, was kostengünstiger ist und größere Anlagen erlaubt. Der Wechselrichter selber kann an seiner maximalen Spannung betrieben werden, wodurch eine bessere Ausnutzung seiner Dimensionierung, d.h. der Spannungsfestigkeit der verbauten Kondensatoren und elektronischer Bauelemente, der Verdrahtung etc. erreicht wird.
Wird der Photovoltaikgenerator mit einem frei schwebenden Potential betrieben, hat der Grenzwert mindestens die Hälfte der vorgebbaren Strangspannung im Leerlauffall zu betragen.

Es ist vorteilhaft, wenn der erste oder der zweite Grenzwert mindestens 3% dem Betrage nach kleiner sind als die niedrigste zulässige Spannungsfestigkeit aller beteiligten spannungsführenden Bauteile, wie z.B. einer Klemme, eines Kabels, des Photovoltaikmoduls usw. So richtet sich die Kurzschlussschaltung nach dem schwächsten Glied in der Kette, was in der Regel das Photovoltaikmodul ist, bei älteren umgerüsteten Anlagen aber auch andere Komponenten sein können.
Der zweite Grenzwert sollte dem Betrage nach mindestens 3% kleiner sein als die niedrigste, im Regelalgorithmus des MPP-Reglers der Photovoltaikanlage niedergelegte Arbeitspunktspannung. Dies verhindert, dass bei dem Einsatz von TCO - Photovoltaikmodulen mit ihrem bekannten Problem der Kathodenerosion bei negativem Potential, diese TCO - Module weiterlaufen und sich selbst zersetzen.
Bei Ausführung der Erfindung ist es nicht erforderlich, dass ein weiteres Kurzschluss-Schaltelemente zwischen dem Pluspol und dem Minuspol der Gleichspannungsseite des Wechselrichters vorhanden ist.

Zur Schonung der Kondensatoren und der elektronischen Bauteile im Wechselrichter ist es vorteilhaft, wenn das erste und das zweite Schaltelement zeitgleich geöffnet werden. Dabei kann der Schließvorgang des dritten Schaltelements zusammen mit dem Öffnungsvorgang des ersten und/oder des zweiten Schaltelements eingeleitet werden, was insbesondere dadurch erreicht wird, dass alle drei Schaltelemente einen gemeinsamen Antrieb haben. Diese Maßnahme stellt sicher, dass der Schließvorgang des dritten Schaltelements nicht stattfindet, bevor der Öffnungsvorgang zumindest soweit fortgeschritten ist, dass der wegen des hohen vorliegenden Gleichstroms erzeugte Lichtbogen in den ersten beiden Schaltelementen einen Großteil der ansonsten Richtung Wechselrichter fließenden Energie absorbiert hat. Idealerweise ist der Antrieb mechanisch derart zwangsgeführt, dass während der Lichtbogen noch über die Schaltkontakte des ersten und ggf. des zweiten Schaltelements anliegt, der Schließvorgang des dritten Schaltelements soweit fortgeschritten ist, dass die Kontaktzusammenführung unmittelbar vor oder nach dem Erlöschen des oder der Lichtbögen stattfindet.
Hinsichtlich der Verwendung der erfindungsgemäßen Vorrichtung ist es ausreichend, wenn alle Schaltelemente auf einen einmaligen Gebrauch ausgelegt sind. Es soll einem unwahrscheinlichen und eher seltenen Zustand begegnet werden, in welchem die Netzseite des Wechselrichters ohne Vorwarnung ausgefallen ist oder in welchem ein Erdschluss seitens des Photovoltaikgenerators vorliegt. Je nach Qualität oder Belastbarkeit des Erdschlusses kann dieser dazu führen, dass die gesamte in den Kondensatoren des Wechselrichters gespeicherte Energie, eventuell noch verstärkt um die aus dem Versorgungsnetz in Richtung Wechselrichter fließende Energie in den Photovoltaikgenerator geleitet wird. Alternativ zu dem Einmalschalter kommt auch ein per Hand zurücksetzbarer Schalter in Frage.
Weitere Vorteile und Einzelheiten der Erfindung ergeben sich aus der Beschreibung eines Ausführungsbeispiels anhand der folgenden Figur, die ein Schema einer erfindungsgemäßen PV-Anlage mit drei Schaltelementen auf der Gleichspannungsseite zeigt.

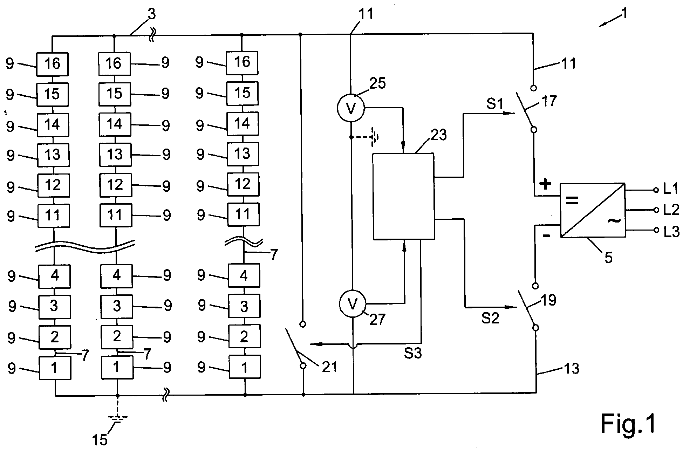

In der Figur ist mit 1 eine Photovoltaikanlage bezeichnet, die als wesentliche Elemente einen Photovoltaikgenerator 3 und einen Wechselrichter 5 umfasst. Der PV-Generator 3 weist eine Anzahl parallel geschalteter Stränge 7 auf, die jeweils aus einer Reihenschaltung von 16 Photovoltaikmodulen 9 bestehen. Die Enden der Stränge 7 bilden einen Pluspol 11 beziehungsweise einen Minuspol 13.
Um auf das im einleitenden Teil angeführte Zahlenbeispiel zurückzugreifen, bei dem ein PV-Modul 9 zu jeweils 120 Zellen vorgestellt wurde, von denen jede eine Betriebsspannung von 0,5 Volt und eine Leerlaufspannung von 0,75 Volt aufweist, ergibt sich für jeden Strang 7 mit seinen 16 PV-Modulen 9 eine Leerlaufstrangspannung zwischen dem Pluspol 11 und dem Minuspol 13 von 1440 Volt. Im Betrieb des PV-Generators stellt sich dann eine Betriebsspannung zwischen den Polen von 960 Volt ein. Die Betriebsspannung ist für die PV-Module 9 und den Wechselrichter 5 ungefährlich und nutzt die zulässige Spannungsgrenze von 1000 Volt gut aus. Bei einem geplanten Abschalten des PV-Generators 3 vom Netz wird über entsprechende Maßnahmen seitens der MPP-Regelung vermieden, dass die Leerlaufspannung von 1440 Volt, die zu Schäden führen kann, an den Modulen 9 und dem Gleichspannungseingang des Wechselrichters 5 anliegt. Bleibt die Leistungsabgabe an der Wechselspannungsseite des Wechselrichters 5 allerdings ungeplant aus, springt die Eingangsspannung an der Gleichspannungsseite auf den Wert der Leerlaufspannung von 1440 Volt, was zu vermeiden ist.

Eine andere ungeplante Spannungserhöhung kann durch einen Erdschluss oder einen schleichenden Erdfehler 15 auftreten, der an einer der Verbindungsleitungen zwischen den PV-Modulen, zwischen den Strängen oder zu dem Wechselrichter 5 auftritt. Ein solcher Erdfehler 15 ist in der Figur durch ein gestrichelt ausgeführtes Massezeichen symbolisiert. Zur besseren Verständlichkeit ist der Erdfehler 15 unten am ersten Modul 9 eingezeichnet. An jeder anderen Stelle führt er im Prinzip zu demselben Effekt, lediglich etwas schleichender. Der Erdfehler 15 ist in der Regel kein belastbarer Kurzschluss, sondern bewirkt einen reduzierten Übergangswiderstand zur Masse, der aber ausreicht, um das Potential an diesem Punkt zu verschieben. Die Verschiebung hat zur Folge, dass im Leerlauffall der Minuspol 13 nicht mehr frei floatet, sondern in Richtung Masse verlegt ist. Aus Gründen der Anschaulichkeit wird von einem nicht Strom-belastbaren Masseschluss ausgegangen. Tritt jetzt ein Leerlaufzustand auf, so würde sich am ersten Modul 9 unten eine Leerlaufspannung von 90 Volt aufbauen, bei dem darüber liegenden zweiten Modul 9 von 180 Volt, bei dem nächsten Modul 9 von dreimal 90 Volt = 270 Volt etc. Von Modul 9 zu Modul 9 erhöht sich die Spannung am Modul 9 um 90 Volt, was ab dem zwölften Modul 1080 Volt ausmacht, also jenseits der Zulässigkeit liegt.
Hier setzt die Erfindung ein, indem zwischen dem Plus-Wechselrichtereingang und dem Pluspol 11 des Photovoltaikgenerators 3 ein erstes Schaltelement 17. In analoger Weise ist zwischen dem Minus-Wechselrichtereingang und dem Minuspol 13 des Photovoltaikgenerators 3 ein zweites Schaltelement 19 vorgesehen. Im normalen, störungsfreien Betrieb der Photovoltaikanlage 1 sind beide Schalter 17, 19 geschlossen und verbinden die Gleichspannungsseite des Wechselrichters 5 mit dem Pluspol 11 bzw. dem Minuspol 13 des Photovoltaikgenerators 3.

Vom Wechselrichter 5 her gesehen, ist hinter den Schaltelementen 17, 19 ein drittes Schaltelement 21 angeordnet, welches im geschlossenen Zustand den Pluspol 11 und den Minuspol 13 miteinander verbindet, also den Photovoltaikgenerator 3 kurzschließt. Das dritte Schaltelement 21 ist im ungestörten Betriebszustand der Photovoltaikanlage 1 geöffnet, so dass der photovoltaisch erzeugte Strom zu dem Wechselrichter 5 fließt.

Die Schaltelemente 17, 19 und 21 werden von Steuersignalen S1, S2 bzw. S3 gesteuert, die von einer Steuervorrichtung 23 generiert werden. Der Steuervorrichtung 23 werden als Eingangssignale der von einer am Pluspol 11 angeschlossenen ersten Messvorrichtung 25 ermittelte, am Pluspol 11 anliegende Spannungswert gegenüber Erde, sowie der von einer am Minuspol 13 angeschlossenen zweiten Messvorrichtung 27 ermittelte, am Minuspol 13 anliegende Spannungswert gegen Erde zugeführt. Der Öffnungsvorgang der Schaltelemente 17, 19 läuft dabei wie folgt ab: Die erste Messvorrichtung 25 ermittelt einen Spannungswert oberhalb eines Grenzwerts von z.B. 1000 Volt, was von der Steuervorrichtung 23 erkannt wird, die daraufhin die Schaltsignale S1, S2 an das erste Schaltelement 17 beziehungsweise das zweite Schaltelement 19 abgibt, woraufhin diese öffnen. Es werden mechanische Schaltelemente 17, 19, 21 eingesetzt, die eine gewisse Zeit brauchen, um den eigentlichen Öffnungsvorgang mit dem Lösen der Schaltkontakte voneinander einzuleiten. Dies ist bauartbedingt und ergibt sich aus der Trägheit der beteiligten Komponenten, Toleranzen etc. Mit dem Lösen der Schaltkontakte voneinander wird aufgrund des hohen fließenden Gleichstroms von bis zu mehreren Hundert Ampere jedes Schaltelement 17, 19 einen Lichtbogen ausbilden, der die Energie des Gleichstroms in ionisiertes Gas, ein Verdampfen des Kontaktmaterials und ggf. des isolierenden Umgebungsmaterials umsetzt.

Zeitgleich mit dem Öffnen des ersten und des zweiten Schaltelements 17, 19 wird der Schließvorgang beim dritten Schaltelement 21 eingeleitet. Vorausgesetzt das dritte Schaltelement weist identisches Schaltverhalten wie das erste und das zweite Schaltelement auf, so wird unmittelbar nach Einsetzen der Kontaktbewegung voneinander weg bei dem ersten und dem zweiten Schaltelement 17 bzw. 19 aufeinander zu bei dem dritten Schaltelement 21, die gleiche Wegstrecke der Schaltkontakte aller drei Schaltelemente 17, 19, 21 zurückgelegt worden sein. Das heißt elektrisch: An dem ersten und dem zweiten Schaltelement steht ein Lichtbogen an und beim dritten Schaltelement 21 ist der Abstand der Schaltkontakte noch nicht nahe genug, um einen Lichtbogen zu zünden. Diese Situation ändert sich im weiteren Verlauf der Schaltkontaktbewegungen, wobei die Plasmasäule der Lichtbögen des ersten und zweiten Schaltelements 17, 19 immer dünner wird und der Abstand der Schaltkontakte des dritten Schaltelements 21 so klein ist, dass auch hier ein Lichtbogen beim Schließvorgang erzeugt wird.
Diese Vorgehensweise ermöglicht ein sehr schnelles Trennen des Photovoltaikgenerators 3 vom Wechselrichter 5 und damit auch vom Netz L1, L2, L3. Nach Abschluss aller Schaltkontaktbewegungen, ist der Photovoltaikgenerator 3 kurzgeschlossen und hat keine elektrische Verbindung mehr zum Netz, so dass keines der beteiligten Bauelemente des PV-Generators, wie Befestigungsklemmen, Kabel, Kabelverzweigungen, Kabelschuhe, Photovoltaikmodule usw. mehr Spannung führt.

Es ist auch möglich, die Schaltsignale S1 und S2 einerseits und S3 andererseits zeitversetzt zu erzeugen, um einen optimalen Zeitpunkt zwischen dem Öffnungsvorgang des ersten und des zweiten Schaltelements 17, 19 und dem dritten Schaltelement 21 zu erzielen.

Die Schaltelemente 17, 19, 21 können dabei auf chemischer, elektrischer, elektronischer oder mechanischer Grundlage arbeiten und insbesondere Varistoren oder IGBTs sein. Insbesondere kann bei der Dimensionierung aller Schaltelemente 17, 19, 21 berücksichtigt werden, dass sie auf einen einmaligen Gebrauch ausgelegt sein können. Die Schalteranordnung stellt einen Sicherungsmechanismus dar, der nur bei einem seltenen Ausnahmefall zum Einsatz kommt. Es ist daher wirtschaftlicher, Einmal-Schaltelemente 17, 19, 21 herzunehmen und diese im Bedarfsfall zu ersetzen, als einen konstruktiven Mehraufwand für mehrmaliges Schalten vorzunehmen. Denkbar ist hierbei auch, Schaltelemente 17, 18, 19 einzusetzen, die nicht nur einmal aber eben auch nicht oft geschaltet werden können, um so die Lücke zwischen Einmalschaltelemente und z.B. elektrische Schütze, die mehrere tausend mal schalten können, zu schließen. Vorzugsweise sind zwischen 5 und dreißig Schalthandlungen erstrebenswert, um die Anzahl der Schalthandlungen mit der Lebenserwartung des PV-Systems in Einklang zu bringen.

Der erste und der zweite Grenzwert können über nicht gezeigte Einstellmittel an der Steuervorrichtung 23 eingestellt werden, oder es können vorbestimmte Grenzwerte genommen werden, die fest in der Steuervorrichtung 23 vorprogrammiert sind und mit den Messwerten der ersten und der zweiten Messvorrichtung 25, 27 verglichen werden.

Es ist vorteilhaft, wenn alle drei Schaltelemente 17, 19, 21 einen gemeinsamen Antrieb haben, insbesondere wenn dieser zwangsgeführt ist. Dieses kann z.B. durch zwei sich relativ zueinander bewegende Teile geschehen, von denen in einem Schaltkontakte der drei Schaltelemente 17, 18, 19 integriert sind und im anderen Teil die Gegenkontakte. Bei den öffnenden Schaltelementen 17, 19 stehen sich die Kontakte und Gegenkontakte gegenüber und werden durch eine translatorische oder rotorische Bewegung voneinander auseinander bewegt, wohingegen beim schließenden dritten Schaltelement 21 sich der Kontakt und der Gegenkontakt im Ausgangszustand nicht gegenüberliegen und nicht berühren und erst durch dieselbe translatorische oder rotorische Bewegung aufeinander zu bewegt werden, bis sie die gewünschten Kontaktposition einnehmen. Insbesondere bei einem zwangsgeführten Schaltvorgang ist die Integration der drei Schaltelemente 17, 19, 21 in ein einziges Schaltgerät sinnvoll.

### Bezugszeichenliste

- 1: Photovoltaikanlage
- 3: Photovoltaikgenerator
- 5: Wechselrichter
- 7: Strang
- 9: Photovoltaikmodul
- 11: Pluspol
- 13: Minuspol
- 15: Erdfehler
- 17: erstes Schaltelement
- 19: zweites Schaltelement
- 21: drittes Schaltelelement
- 23: Steuervorrichtung
- 25: erste Messvorrichtung
- 27: zweite Messvorrichtung
- S,S1,S2: Steuersignal
- L1,L2,L3: Netz

## Patentansprüche

1. Photovoltaikanlage (1) mit einem Photovoltaikgenerator (3), welcher mehrere parallel angeordnete Stränge (7) von in Serie verbundenen Photovoltaikmodulen (9) umfasst, wobei die Stränge einen Plus- und einen Minuspol (11 bzw. 13) aufweisen zwischen denen eine über die Anzahl der in Serie geschalteten Photovoltaikmodule vorgebbare Strangspannung anliegt, die im Leerlauffall des Photovoltaikgenerators mehr als 1000 Volt beträgt, und mit einem Wechselrichter (5), dessen Gleichspannungseingang mit den beiden Polen verbunden ist, und der ausgangsseitig mit einem Versorgungsnetz (L1,L2,L3)verbindbar ist, **dadurch gekennzeichnet, dass** der Pluspol und der Minuspol über ein erstes, beziehungsweise über ein zweites Schaltelement (17, 19) mit dem Gleichspannungseingang des Wechselrichters verbindbar sind, dass eine Steuervorrichtung (23) vorgesehen ist, mittels der zumindest eines der beiden Schaltelemente (17, 19) geöffnet wird, wenn die Spannung des Pluspols gegenüber Erde einen ersten vorgegebenen Grenzwert übersteigt oder wenn die Spannung des Minuspols gegenüber Erde einen zweiten vorgegebenen Grenzwert dem Betrage nach überschreitet und dass mittels der Steuervorrichtung ein drittes, zwischen dem Pluspol und dem Minuspol angeordnetes Schaltelement (21) geschlossen wird, während das erste und/oder das zweite Schaltelement öffnen/öffnet oder wenn zumindest eines geöffnet ist, wobei das geschlossene dritte Schaltelement den Pluspol und den Minuspol miteinander verbindet.

2. Photovoltaikanlage nach Anspruch 1, **dadurch gekennzeichnet, dass** der Photovoltaikgenerator (3) mit einem frei schwebenden Potential betreibbar ist und der vorgegebene Grenzwert mindestens die Hälfte der vorgebbaren Strangspannung im Leerlauffall beträgt.

3. Photovoltaikanlage nach einem der Ansprüche 1 oder 2, **dadurch gekennzeichnet, dass** das erste und das zweite Schaltelement (17, 19) zeitgleich geöffnet werden.

4. Photovoltaikanlage nach einem der Ansprüche 1 bis 3, **dadurch gekennzeichnet, dass** der Schließvorgang des dritten Schaltelements (21) zusammen mit dem Öffnungsvorgang des ersten und/oder zweiten Schaltelements (17, 19) eingeleitet wird.

5. Photovoltaikanlage nach Anspruch 4, **dadurch gekennzeichnet, dass** alle drei Schaltelemente (17, 19, 21) einen gemeinsamen Antrieb haben.

6. Photovoltaikanlage nach Anspruch 5, **dadurch gekennzeichnet, dass** der Antrieb mechanisch zwangsgeführt ist.

7. Photovoltaikanlage nach Anspruch 6, **dadurch gekennzeichnet, dass** alle Schaltelemente (17, 19,21) auf einen einmaligen Gebrauch ausgelegt sind.

8. Photovoltaikanlage nach einem der Ansprüche 4 bis 7, **dadurch gekennzeichnet, dass** der erste oder der zweite Grenzwert mindestens 3% dem Betrage nach kleiner sind als die niedrigste zulässige Spannungsfestigkeit aller beteiligten spannungsführenden Bauteile, wie z.B. einer Klemme, eines Kabels, des Photovoltaikmoduls usw.

9. Photovoltaikanlage nach einem der Ansprüche 4 bis 7, **dadurch gekennzeichnet, dass** der zweite Grenzwert dem Betrage nach mindestens 3% kleiner ist als die niedrigste, im Regelalgorithmus des MPP-Reglers der Photovoltaikanlage (1) niedergelegte Arbeitspunktspannung.

10. Photovoltaikanlage nach einem der Ansprüche 1 bis 9, **dadurch gekennzeichnet, dass** kein weiteres Kurzschluss-Schaltelement zwischen dem Pluspol (11) und dem Minuspol (13) der Gleichspannungsseite des Wechselrichters (5) vorhanden ist.

## Claims

1. Photovoltaic system (1) with a photovoltaic generator (3), which comprises a plurality of strands (7) of photovoltaic modules (9) connected in series, the strands having a positive and a negative pole (11 and 13) between which a pre-settable strand voltage is applied via the number of photovoltaic modules connected in series, which in the case of idling of the photovoltaic generator is more than 1000 volts, and with an inverter (5), whose DC voltage input is connected to the two poles, and whose output side may be connected to a supply network (L1, L2 , L3), **characterised in that** the positive pole and the negative pole can be connected to the DC voltage input of the inverter via a first or a second switching element (17, 19), that a control device (23) is provided by means of which at least one of the two switching elements (17, 19) is opened when the voltage of the positive pole with respect to earth exceeds a first predetermined limit value or when the voltage of the negative pole with respect to earth exceeds a second predetermined limit value in terms of amount, and that the control device closes a third switching element (21) arranged between the positive pole and the negative pole while the first and/or the second switching element opens or when at least one is opened, so that the closed third switching element connects the positive pole and the negative pole.

2. Photovoltaic system according to claim 1, **characterised in that** the photovoltaic generator (3) can be operated with a free floating potential and the predetermined limit value is at least half of the pre-settable strand voltage in the idle state.

3. Photovoltaic system according to one of claims 1 or 2, **characterised in that** the first and the second switching element (17, 19) are opened at the same time.

4. Photovoltaic system according to one of claims 1 to 3, **characterised in that** the closing process of the third switching element (21) is initiated together with the opening process of the first and/or second switching element (17, 19).

5. Photovoltaic system according to claim 4, **characterised in that** all three switching elements (17, 19, 21) have a common drive.

6. Photovoltaic system according to claim 5, **characterised in that** the drive is mechanically positively driven.

7. Photovoltaic system according to claim 6, **characterised in that** all switching elements (17, 19, 21) are designed for single use.

8. Photovoltaic system according to one of claims 4 to 7, **characterised in that** the first or the second limit value is at least 3% smaller than the lowest permissible dielectric strength of all voltage-carrying components involved, such as a terminal, a cable, the photovoltaic module, etc.

9. Photovoltaic system according to one of claims 4 to 7, **characterised in that** the amount of the second limit value is at least 3% smaller than the lowest operating point voltage stored in the control algorithm of the MPP controller of the photovoltaic system (1).

10. Photovoltaic system according to one of claims 1 to 9, **characterised in that** there is no further short-circuit switching element between the positive pole (11) and the negative pole (13) of the DC voltage side of the inverter (5).

## Revendications

1. Installation photovoltaïque (1) comprenant un générateur photovoltaïque (3), lequel comporte une pluralité de ternes (7) des modules photovoltaïques (9) connectés en série, lesdites ternes comportant un pôle positif et un pôle négatif (11 et 13) entre lesquels une tension de terne pouvant être prédéterminée est appliquée sur le nombre de modules photovoltaïques connectés en série, laquelle tension, lors du fonctionnement du générateur photovoltaïque au ralenti, est supérieure à 1 000 volts et un onduleur (5), dont l'entrée de tension continue est connectée aux deux pôles et lequel peut être connecté côté sortie à un réseau d'alimentation (L1, L2, L3), **caractérisée en ce que** le pôle positif et le pôle négatif peuvent être connectés, à l'aide d'un premier ou à l'aide d'un deuxième élément de commutation (17, 19), à l'entrée de tension continue de l'onduleur, **en ce qu'**un dispositif de commande (23) est prévu, qui permet d'ouvrir au moins un des deux éléments de commutation (17, 19) lorsque la tension du pôle positif dépasse par rapport à la terre une première valeur limite prédéterminée ou lorsque la tension du pôle négatif dépasse par rapport à la terre une deuxième valeur limite prédéterminée et **en ce qu'**au moyen du dispositif de commande, un troisième élément de commutation (21), disposé entre le pôle positif et le pôle négatif, est fermé, lorsque le premier et/ou le deuxième élément de commutation est ouvert ou lorsque au moins un desdits éléments de commutation est ouvert, le troisième élément de commutation fermé connectant le pôle positif et le pôle négatif l'un à l'autre.

2. Installation photovoltaïque selon la revendication 1, **caractérisée en ce que** le générateur photovoltaïque (3) peut fonctionner avec un potentiel librement flottant et la valeur limite prédéterminée représente au moins la moitié de la tension de terne pouvant être prédéterminée lors du fonctionnement au ralenti.

3. Installation photovoltaïque selon l'une quelconque des revendications 1 ou 2, **caractérisée en ce que** le premier et le deuxième élément de commutation (17, 19) sont ouverts en même temps.

4. Installation photovoltaïque selon l'une quelconque des revendications 1 à 3, **caractérisée en ce que** le processus de fermeture du troisième élément de commutation (21) est lancé conjointement avec le processus d'ouverture du premier et/ou du deuxième élément de commutation (17, 19).

5. Installation photovoltaïque selon la revendication 4, **caractérisée en ce que** les trois éléments de commutation (17, 19, 21) ont un entraînement commun.

6. Installation photovoltaïque selon la revendication 5, **caractérisée en ce que** l'entraînement est guidé mécaniquement de manière forcée.

7. Installation photovoltaïque selon la revendication 6, **caractérisée en ce que** tous les éléments de commutation (17, 19, 21) sont conçus pour un usage unique.

8. Installation photovoltaïque selon l'une quelconque des revendications 4 à 7, **caractérisée en ce que** la première ou la deuxième valeur limite est inférieure d'au moins 3 % à la rigidité diélectrique admissible la plus basse de tous les composants sous tension concernés, tels que, par exemple, une borne, un câble, du module photovoltaïque, etc.

9. Installation photovoltaïque selon l'une quelconque des revendications 4 à 7, **caractérisée en ce que** la deuxième valeur limite est inférieure d'au moins 3 % à la tension de point de polarisation la plus basse définie dans l'algorithme de régulation du régulateur MPP de l'installation photovoltaïque (1).

10. Installation photovoltaïque selon l'une quelconque des revendications 1 à 9, **caractérisée en ce qu'**il n'existe aucun autre élément de commutation de court-circuit entre le pôle positif (11) et le pôle négatif (13) du côté tension continue de l'onduleur (5).
